# EUROPEAN PATENT SPECIFICATION

(11) **EP 0 477 907 B1**
(45) Date of publication and mention of the grant of the patent: **17.04.1996**
(21) Application number: 91116347.5
(22) Date of filing: 25.09.1991
(51) Int. Cl.: G05F 1/56, G05F 3/28, G05F 3/22, H03K 3/023, G06F 1/32, G06F 1/08

(54) **A constant current circuit and an oscillating circuit controlled by the same**
Konstantstromschaltung und ein Schwingkreis gesteuert durch dieselbe
Circuit de courant constant et un circuit oscillant commandé par ledit circuit

(30) Priority: 26.09.1990 JP 256294/90
(43) Date of publication of application: 01.04.1992
(60) Divisional application: 95102887.7
(73) Proprietor: FUJITSU LIMITED, Kawasaki-shi, Kanagawa 211 (JP)
(72) Inventor: Suwada, Makoto, c/o FUJITSU LIMITED, Kawasaki-shi, Kanagawa 211 (JP); Inoue, Shuichi, c/o FUJITSU LIMITED, Kawasaki-shi, Kanagawa 211 (JP); Usui, Yuzo, c/o FUJITSU LIMITED, Kawasaki-shi, Kanagawa 211 (JP)
(74) Representative: Stebbing, Timothy Charles

(56) References cited:
- EP-A- 0 165 748
- EP-A- 0 263 572
- IBM TECHNICAL DISCLOSURE BULLETIN. vol. 19, no. 4, September 1976, NEW YORK US pages 1375 - 1376 J. D. LEPAGE ET AL. 'Voltage-To-Current Converter'
- ELECTRONIC LETTERS; vol.26, no.10; May 1990; pgs.619-620.

## Description

The present invention relates to a constant current circuit, which can be used for example to control an oscillating circuit for providing a variable-frequency clock generator in a battery-powered computer.

Various methods for saving electric power are implemented in computers powered by batteries. For example, the operating voltage is reduced in operation modes not requiring high speed, e.g. mode selection prior to arithmetic processing, together with lowering the clock signal frequency. The lower operating voltage and lower clock signal frequency both help to reduce power consumption.

In conventional battery-powered computers, one of the following techniques is used for changing the clock signal frequency. The first is to provide multiple oscillators for generating clock signals of different frequencies, and to select a suitable one of the oscillators when performing, for example, a high-speed operation such as arithmetic processing or a low-speed operation such as mode selection. The second is to provide a single oscillator of a relatively high frequency, and obtain a desired low frequency by demultiplying the high frequency. However, both these techniques involve drawbacks of requiring extra hardware such as oscillators and selecting circuits, and of increase in the cost of the computers. Another drawback of the conventional techniques is that the clock frequency cannot be continuously varied.

Electronics Letters, vol. 26, no. 10, 1st May 1990, pages 619 - 621 discloses a bipolar linear transconductor having the features of the preamble of accompanying claim 1. The transconductor receives an input voltage independently of a power voltage.

IBM Technical Disclosure Bulletin, vol. 19, no. 4, September 1976, pages 1375 - 1376, discloses a voltage-to-current converter in which an output current is linearly related to an input voltage difference. The input voltage is for example a difference between a video output voltage from an optical scanner and a black-peak reference voltage.

According to the present invention, there is provided a constant current circuit having a source for supplying a power voltage, constant current supplying means including at least one constant current supplying source, first and second transistors connected between the power voltage supplying source and the constant current supplying means, each of the transistors having a control electrode, and a resistance means including at least one resistor, connected between respective nodes of the first and second transistors and connected to the constant current supplying means characterised in that the control electrode of the first transistor is provided with a reference voltage and the constant current circuit further comprises a voltage divider providing a divided voltage of the power voltage for the control electrode of the second transistor, whereby the current flowing in the second transistor is controlled according to the magnitude of said power voltage, and the rate of change of the current with respect to change of the power voltage depends on the resistance of the resistance means, said resistance being chosen such that the second transistor outputs a current which linearly changes with the power voltage.

The present invention may be applied to control of an oscillating circuit capable of generating clock signals of higher frequency for operations such as arithmetic processing and of lower frequency for operations such as mode selection, with a simple circuit configuration and at low cost, and/or to an oscillating circuit which generates higher or lower frequency clock signals in response to a change in the power source voltage, for example having an oscillation frequency which can be continuously changed by changing the power source voltage.

Reference will now be made, by way of example, to the accompanying drawings in which:-
Fig. 1 is a diagram showing the fundamental configuration of a constant current circuit of the present invention;
Fig. 2 is a diagram showing the fundamental configuration of an oscillating circuit which can be controlled by means of the present invention;
Fig. 3 is a graph showing the relationship between power voltage V_{cc} and current I₂ in the constant current circuit of Fig. 1;
Fig. 4 is a graph for explaining the change of the slope of the V_{cc}-I₂ characteristic curve of Fig. 3 with the change of R₄;
Fig. 5 shows waveforms of the signal output from the oscillating circuit of Fig. 2, corresponding to different power voltages V_{cc} in the constant current circuit of Fig. 1;
Fig. 6 is a graph showing the relationship between power voltage V_{cc} in the circuit of Fig. 1 and oscillation frequency f in Fig. 2;
Fig. 7 is a graph showing the change of the slope of the V_{cc}-f curve of Fig. 6 with the change of R₄;
Fig. 8 is a graph for explaining an extended change of I₂ in the V_{cc}-I₂ characteristic of Fig. 3;
Fig. 9 is a graph for explaining an extended change of f in the V_{cc}-f characteristic of Fig. 6;
Fig. 10 is a diagram showing the fundamental configuration of another constant current circuit of the present invention;
Fig. 11 is a diagram showing a first embodiment of the present invention;
Fig. 12 is a graph for explaining the shift of I₄ in the circuit of Fig. 11;
Fig. 13 is a graph for explaining the shift of frequency f in the circuit of Fig. 11;
Fig. 14 shows waveforms of the signal output from the circuit of Fig. 11, corresponding to different values of V_{cc};
Fig. 15 is a diagram showing a second embodiment of the present invention;
Fig. 16 shows waveforms of the signal output from the circuit of Fig. 15, corresponding to different values of V_{cc};
Fig. 17 is a diagram showing a third embodiment of the present invention;
Fig. 18 is a graph showing the V_{cc}-I₄ characteristic of the circuit of Fig. 17;
Fig. 19 is a graph showing the V_{cc}-f characteristic of the circuit of Fig. 17; and
Fig. 20 shows waveforms of the signal output from the circuit of Fig. 17 for different values of V_{cc}.

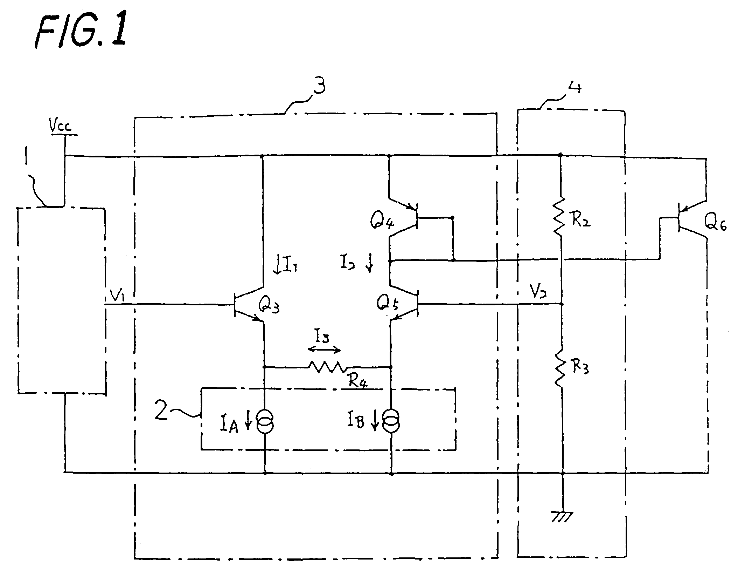

A constant current circuit of the present invention is shown in Fig. 1, which comprises a reference voltage source block 1, a differential amplifier block 3 including a constant current supplying source block 2 and a resistor R₄, and a voltage dividing block 4 for dividing a power source voltage V_{cc}.

Differential amplifier block 3 comprises transistors Q₃ and Q₅, e.g. bipolar transistors each having a collector connected to the power source voltage V_{cc} and an emitter connected to one of the constant current supplying sources I_{A} and I_{B}. The base (control electrode) of the transistor Q₃ is supplied with a reference voltage V₁ from the reference voltage source block 1 and the base of transistor Q₅ is supplied with a divided voltage V₂ of power source voltage V_{cc} from the node of resistors R₂ and R₃ constituting the voltage dividing block 4. The resistor R₄ is connected between the emitters of the transistors Q₃ and Q₅. Hence, a current I₂ dependent on the difference between the voltages V₁ and V₂ flows through the collector of transistor Q₅. The transistor Q₄ provided between the power voltage source V_{cc} and the collector of transistor Q₅ constitutes a current mirror in co-operation with the transistor Q₆. The transistors Q₄ and Q₆ are bipolar transistors, for example, each having an emitter connected to the power voltage source V_{cc} and their bases connected to each other. The base of the transistor Q₄ is also connected to its collector.

Characteristics and operation of the constant current circuit of in Fig. 1 are described later.

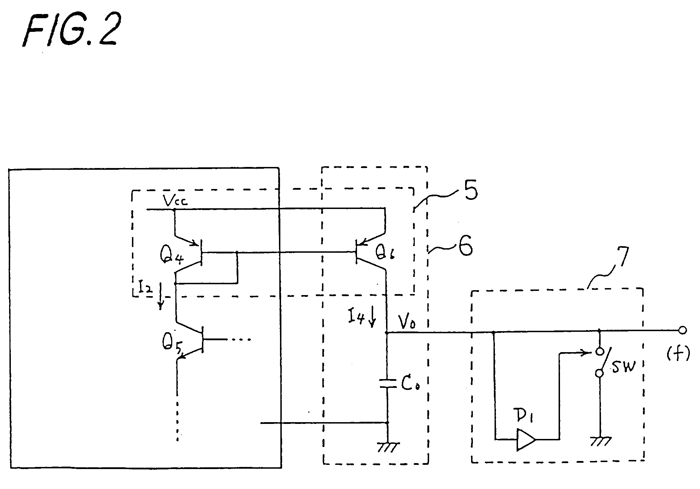

To explain an application of the constant current circuit of the invention, the fundamental configuration of an oscillating circuit is as shown in Figure 2, which comprises a current integration block 6 and a charge-discharge control block 7. The current integration block 6 includes aforementioned transistor Q₆ constituting a current mirror 5, and a capacitor C₀ connected between the collector of the transistor Q₆ and ground potential source. The capacitor C₀ is charged with a current I₄ which is substantially equal to the current I₂ flowing through the transistor Q₄, and the potential V₀ at a terminal of the capacitor C₀ increases with the charging. The charge-discharge control block 7 includes a voltage detection circuit D₁ and a switch means SW. The voltage detection circuit D₁ detects the voltage V₀ of the capacitor C₀ and instructs the switch means SW to close on detecting V₀ higher than a first predetermined voltage (V_{S1}) and to open on detecting V₀ lower than a second predetermined voltage (V_{S2}). Hence, the capacitor C₀ is subject to be charged or discharged along with the ON-OFF operation of the switch means SW, and V₀ changes as a triangular wave of a constant frequency. The frequency can be varied by changing the power source voltage V_{cc} as described later.

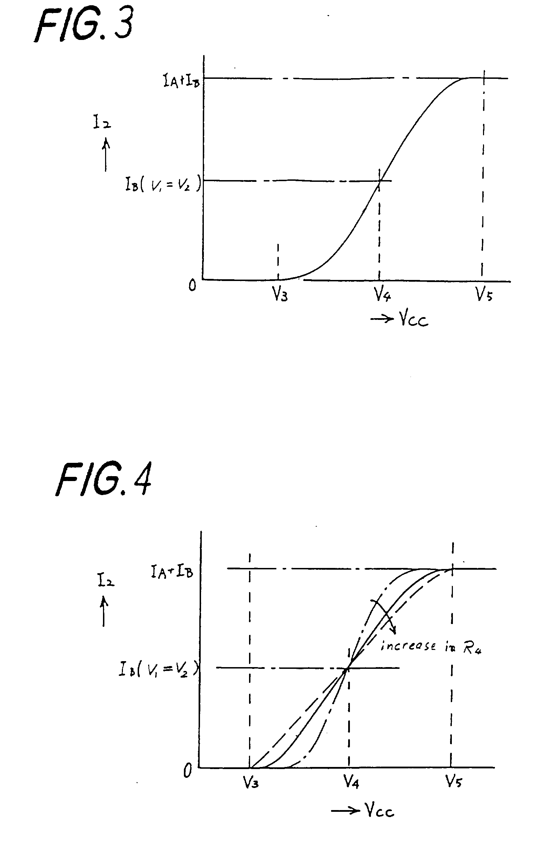

Referring again to Fig. 1 together with Fig. 3, the resistors R₂ and R₃ are selected so that V₂ is equal to V₁ when the power source voltage V_{cc} is V₄, hence, I₂ = I_{B} and the current I₃ flowing through the resistor R₄ is zero. Under this condition, if the power source voltage V_{cc} is increased higher than V₃, V₂ becomes larger than V₁, hence, the current I₂ increases while the current I₁ decreases. Accordingly, the current I₃ flows through the resistor R₄ from the transistor Q₅ to the constant current supplying source I_{A}. At a higher power source voltage V₅, the current I₁ flowing through the transistor Q₃ becomes almost zero, hence, I₂ = I_{A} + I_{B}. If the power source voltage V_{cc} is decreased lower than V₄, V₂ becomes smaller than V_{1,} hence, the current I₁ increases while the current I₂ decreases. Accordingly, the current I₃ flows through the resistor R₄ from the transistor Q₃ to the constant current supplying source I_{B}. At a lower power source voltage V₃, the current I₂ flowing through the transistor Q₅ becomes almost zero, hence, I₂ = 0. As described above, the direction of I₃ flowing through R₄ is reversed at a V_{cc} where V_{cc} = V₄, and I₂ can be changed continuously with V_{cc} so as to be larger than I_{B} in a range where V_{cc}>V₄ and to be smaller than I_{B} in a range where V_{cc}<V₄. If V_{cc} is in the range of V₃(V_{cc}<V₄, I₂ is represented by I₂ = I_{B} - I_{3,} hence, I₂ ≒ I_{B} -(V₁-V₂)/R₄, while, if V_{cc} is in the range of V₄<V_{cc}<V₅, I₂ is represented by I₂ = I_{B} + I₃, hence, I₂ ≒ I_{B} +(V₂-V₁)/R₄. Accordingly, the larger the resistance of the resistor R₄, the larger the current I₂ in the range of V₃(V_{cc}<V₄, while, the larger the resistance of the resistor R₄, the smaller the current I₂ in the range of V₄<V_{cc}<V₅. Thus, the slope of the V_{cc}-I₂ characteristic curve shown in Figure 3 becomes gentle with respect to the increase in R₄. Such change in the V_{cc}-I₂ characteristic curve by the resistance of the resistor R₄ is shown in Figure 4. Accordingly, I₂ can continuously be changed with the change of V_{cc}, if the resistor R₄ is selected to have an enough large resistance. This feature enables the oscillating circuit of Figure 2 to be a variable frequency oscillator.

The operation of the oscillating circuit of Figure 2 with the change of the power source voltage V_{cc} is described in the following.

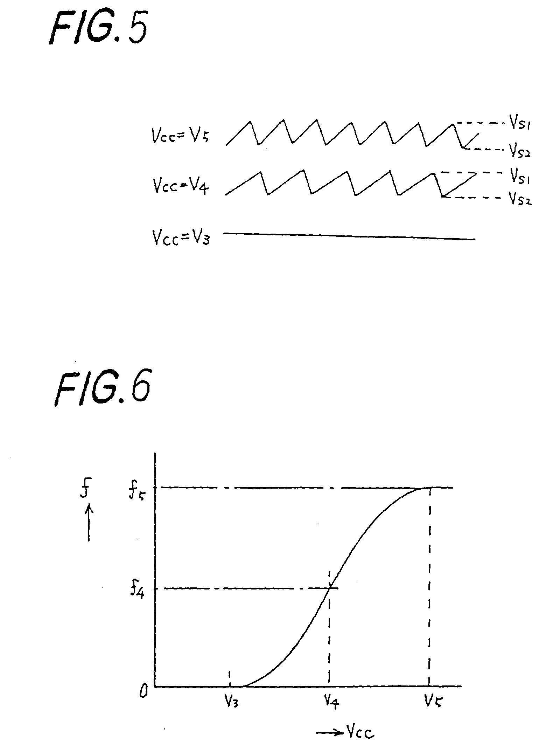

The current I₄ to charge the capacitor C₀ of the oscillating circuit is equal to I₂ flowing through the transistor Q₄ in the constant current circuit of Figure 1, due to the function of the current mirror comprising the transistors Q₄ and Q₆. Hence, the rate of charging the capacitor C₀ depends on the current I₂ which can be controlled by changing the power source voltage V_{cc}. On the other hand, the rate of discharging the capacitor C₀ is constant regardless of the change of V_{cc}. Therefore, the frequency of oscillating circuit of Figure 2 changes according to the change of the power source voltage V_{cc}. Figure 5 shows exemplary waveforms of the signal output from the oscillating circuit of Figure 2, corresponding to aforementioned specific V_{cc}s of V₃, V₄ and V₅, and Figure 6 shows the change in the frequency of the output signal with respect to the change of V_{cc}. In Figure 5, V_{S1} and V_{S2} represent the maximum and minimum of the voltages V₀ at an end of the capacitor C₀, respectively, which are detected by the voltage detection circuit D₁ as described above with reference to Figure 2. On other words, V_{S1} is a voltage V₀ where the discharging of the capacitor C₀ initiates, and, V_{S2} is a voltage V₀ where the charging of the capacitor C₀ initiates. As shown in Figure 5, the rise time of the output signal decreases as V_{cc} increases, while the fall time of the signal is constant because it only depends on the resistance inherent in the switching means SW shown in Figure 2. At a power source voltage where V_{cc} = V₃, the frequency of the output signal is zero as shown in Figures 5 and 6, because the current I₄ becomes zero and the capacitor C₀ is not charged.

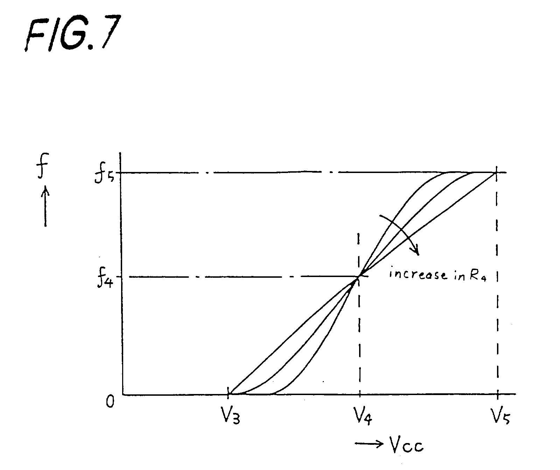

As mentioned before with reference to Figure 4, the slope of V_{cc}-I₂ characteristic curve becomes gentle by increasing the resistance of the resistor R₄. Accordingly, the slope of V_{cc}-f characteristic curve shown in Figure 6 becomes gentle with the increase of R₄ as shown in Figure 7. Thus, it is possible to attain fine tuning of the oscillation frequency f by changing the power source voltage V_{cc}, and the circuit of Figure 2 can be a variable frequency oscillator. It is obvious that if R₄ is decreased to zero, the slope of V_{cc}-I₂ characteristic curve of Figure 4, and hence, the slope of V_{cc}-f characteristic curve of Figure 7 become so steep that the circuit of Figure 2 could not be used as a variable frequency oscillator.

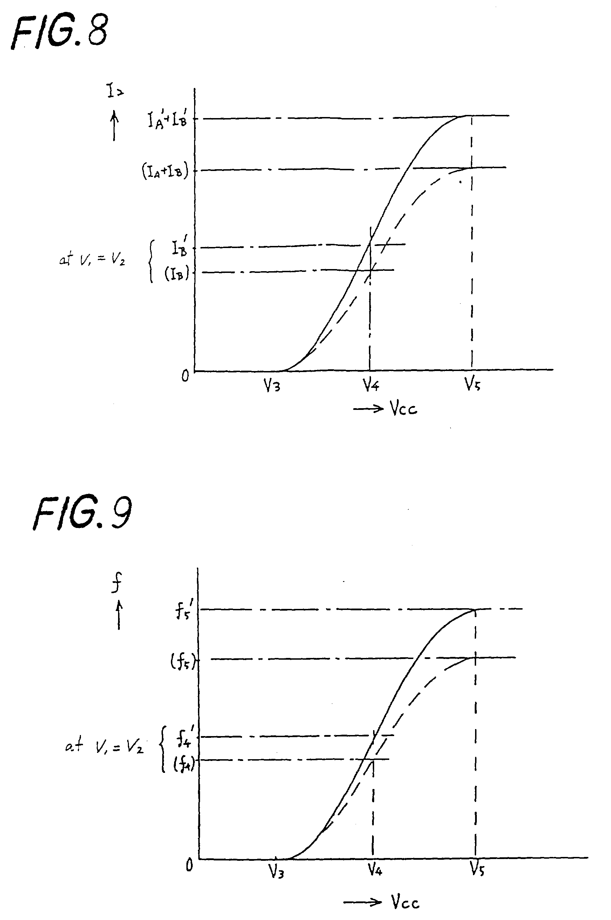

Referring back to Figure 1, if the constant current supplying sources I_{A} and I_{B} are replaced by corresponding ones having larger current capacities I_{A}' and I_{B}', respectively, the change of I₂ in the V_{cc}-I₂ characteristic curve of Figure 3 is extended as shown in Figure 8, hence, the change of f in the V_{cc}-f characteristic curve of Figure 6 is extended as shown in Figure 9. In Figures 8 and 9, respective dotted lines represent original V_{cc}-I₂ characteristic curve corresponding to that in Figure 3 and V_{cc}-f characteristic curve corresponding to that in Figure 6, and f₄' and f₅' respectively indicate the frequencies f₄ and f₅ changed according to the increase in I_{A} and I_{B}.

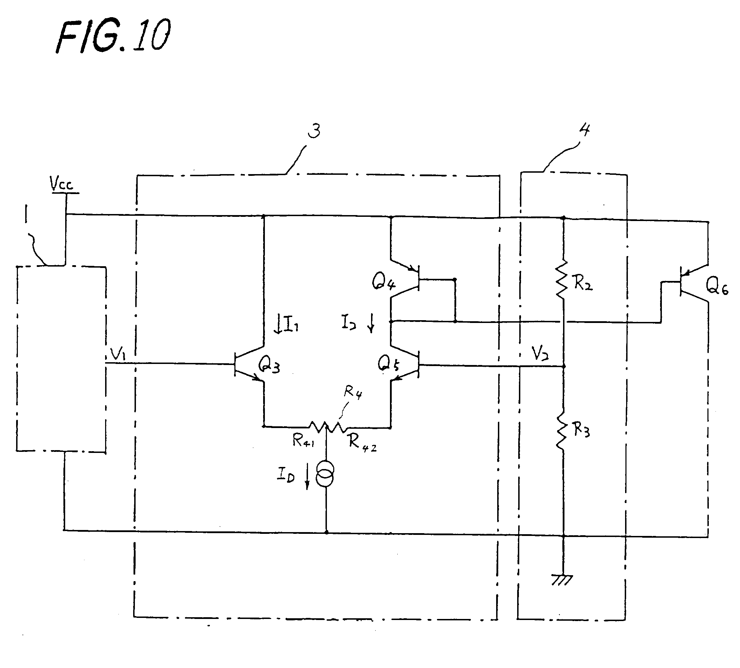

Figure 10 is a diagram showing the fundamental configurations of another constant current circuit of the present invention. The circuit, comprising a reference voltage source 1, a differential amplifier block 3 and a voltage dividing block 4 for dividing power source voltage V_{cc}, is almost the same as the circuit of Figure 1, except for that the Figure 10 circuit includes only one constant current supplying source I_{D} connected to a point on the resistor R₄, the point dividing R₄ into two parts R₄₁ and R₄₂. If R₄ is equally divided, i.e. R₄₁ = R₄₂, the constant current circuit of Figure 10 has the same characteristics as that of the circuit of Figure 1. The feature of R₄ to change the slope of the V_{cc}-I₂ characteristics is also provided. When R₄ is not equally divided, i.e. R₄₁ ≠ R₄₂, the V_{cc}-I₂ characteristic curve regarding the circuit shifts along the V_{cc} axis, wherein the direction and amount of the shift depends on the ratio R₄₁/R₄₂.

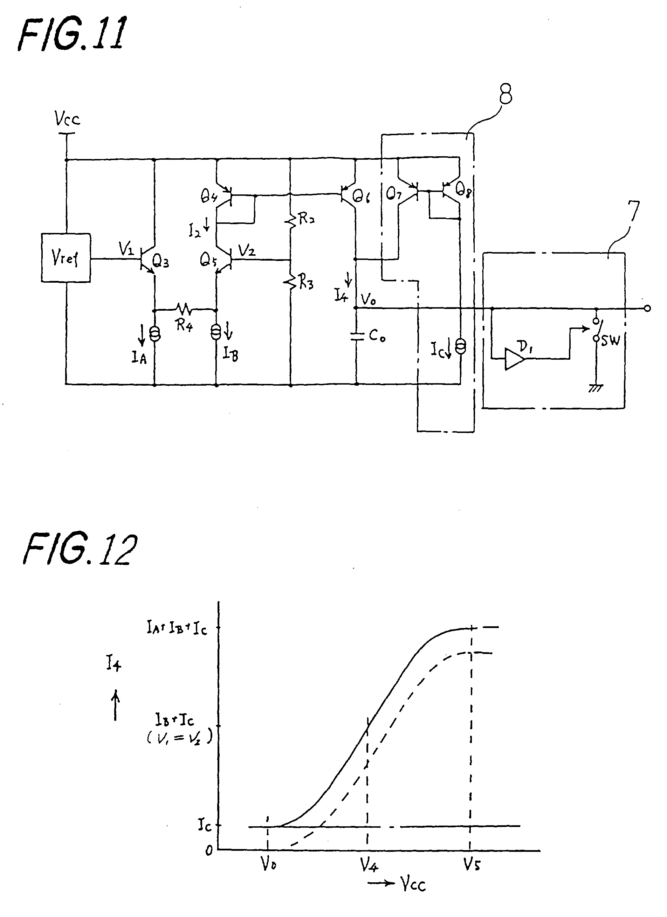

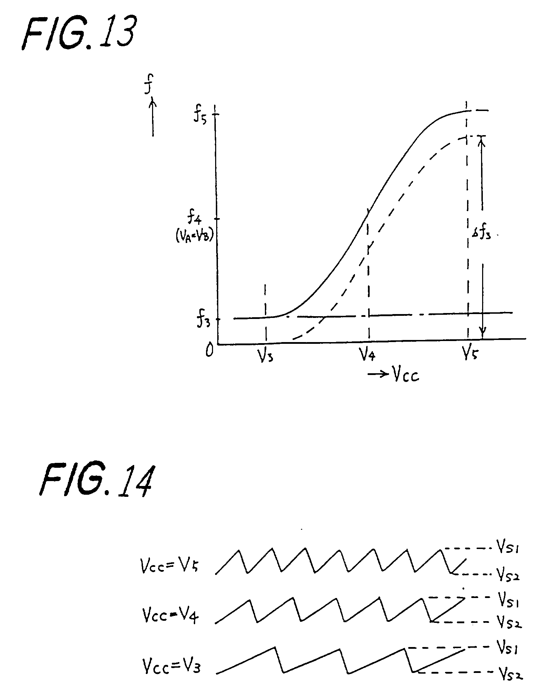

The first embodiment of the constant current circuit of the present invention is shown in Figure 11. The constant current circuit has a configuration based on that of Figure 1 and is applied to control of an oscillating circuit with a configuration based on Figure 2. This embodiment circuit is provided with an additional constant current supplying block 8 including a current mirror comprising transistors Q₇ and Q₈, both bipolar transistors, for example, and a constant current supplying source I_{C} connected to the collector of the transistor Q₈. The current I₄ for charging the capacitor C₀ is increased by the current I_{C} such as represented by I₄ ≒ I₂ + I_{C}. Thus, the current I₄ shifts larger by I_{C} as shown in Figure 12, wherein the dotted line represents the original V_{cc}-I₄ characteristic curve corresponding to that in Figure 3. As a result of the shift, I₄ is not zero but I_{C} at V_{cc} = V₃, different from V_{cc}-I₂ characteristic curve corresponding to that of the circuit shown in Figure 1, in which I₂ is equal to I₄, hence, I₄ is zero at V_{cc} = V₃. Accordingly, the range of the oscillation frequency of the Figure 11 circuit shifts higher by Af as shown in Figure 13, wherein the frequency f is not zero but f₃ at V_{cc} = V₃. In Figure 13, the dotted line represents the original V_{cc}-f characteristic curve corresponding to Figure 6. Waveforms of the signal output from the circuit of Figure 11 are shown in Figure 14, corresponding to the specific V_{cc}s of V₃, V₄ and V₅.

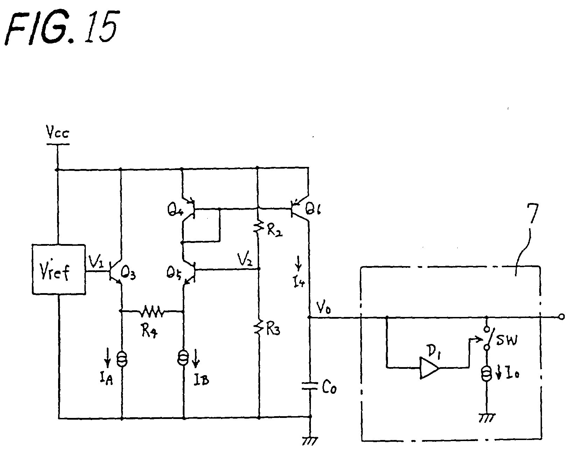

The second embodiment of the present invention is shown in Figure 15. The constant current circuit again has a configuration based on that of Figure 1, and is used to control an oscillating circuit of the Figure 2 type

The oscillator is provided with an additional constant current supplying source I₀ connected in series to the switching means SW in the charge-discharge control block 7. With the addition of the constant current supplying source I₀, the current flowing through the switching means SW during discharging the capacitor C₀ is increased or decreased.

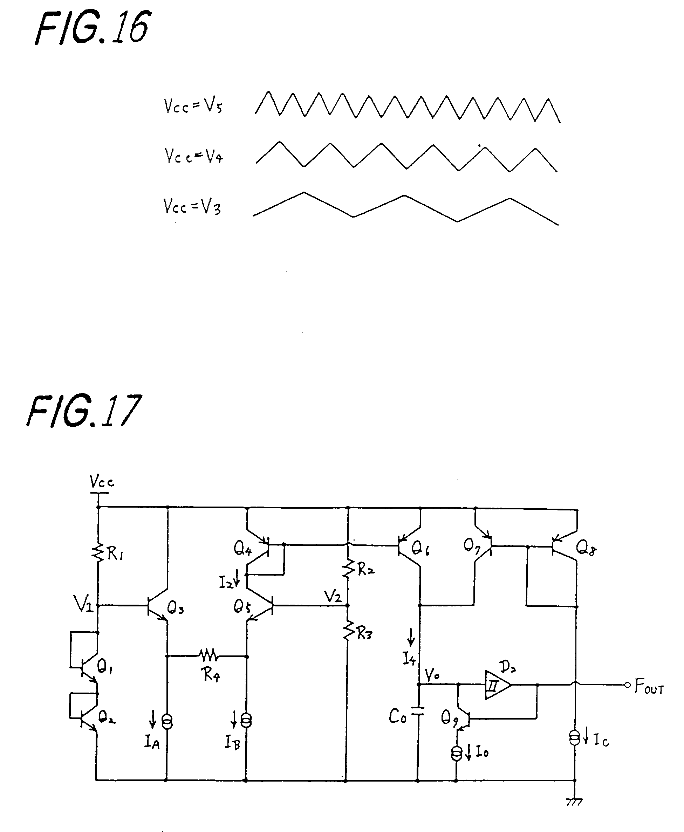

If the current I₀ is selected as I₀ = nI₄, the ratio of the time for discharging to the time for charging of the capacitor C₀ is represented by 1/(n-1), wherein n represents a positive number larger than 1. Thus, the rise time to fall time ratio of the signal output from the circuit of Figure 15 can be controlled, depending on the current capacity of the constant current supplying source I₀. Waveforms of the signal output from the circuit of Figure 15 in which the constant current supplying source I₀ has a current capacity of I₀ = 2 I₄ are shown in Figure 16, corresponding to the specific V_{cc}s of V₃, V₄ and V₅. As seen in Figure 16, the duty factor of each waveform is 50%.

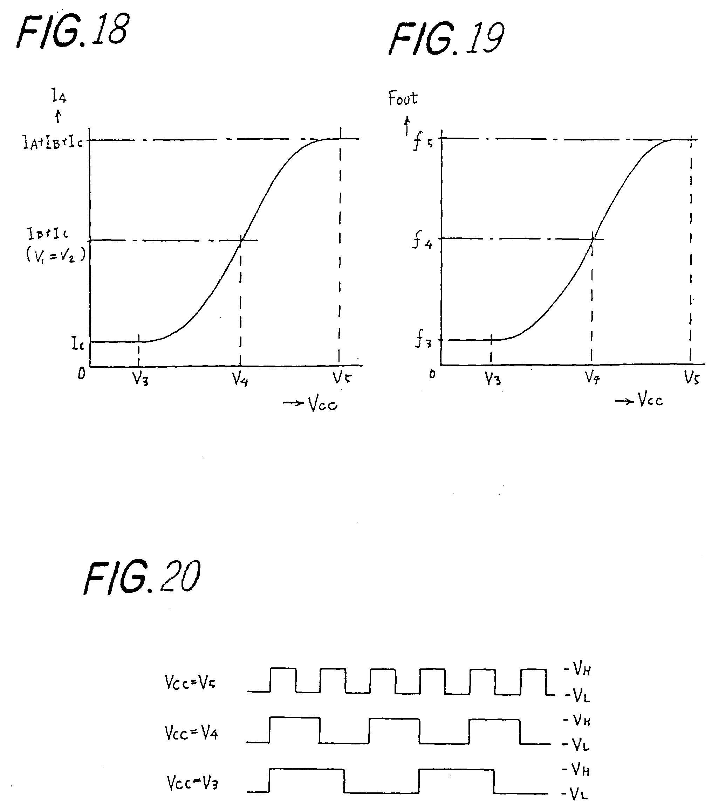

The third embodiment of the present invention is shown in Figure 17, wherein the constant current circuit again has a configuration based on Figure 1 and is shown with an oscillating circuit of the Figure 2 type. Constant current supplying sources I_{C} and I₀ are provided, as explained above with reference to Figures 11 and 15. In the circuit of Figure 17, the transistors Q₁ and Q₂, both bipolar transistors, for example, and a resistor R₁ constitute a source of reference voltage V₁. The base-emitter junction voltage of the transistors Q₁ and Q₂ which are connected to each other in series and supplied with a bias current is used as a constant voltage source. In Figure 17, a transistor Q₃ is used as a switching means and a Schmitt circuit D₂ is used as a voltage detection circuit, respectively corresponding to those denoted by reference symbols SW and D₁ in Figure 11 and 15. The Schmitt circuit D₂ converts triangular pulse signals into rectangular pulse signals thanks to the waveform shaping function thereof based on the inherent hysteresis characteristics between the input and output. The V_{cc}-I₄ characteristics and the V_{cc}-f characteristics of the circuit of Figure 17 are as shown in Figures 18 and 19, respectively.

In the circuit of Figure 17, the Schmitt circuit D₂ has two threshold values of a high level S_{H} and a low level S_{L}, and jumps the output F_{OUT} thereof to high level V_{H}, if V_{O} increases up to the high level threshold S_{H}. Hence, the transistor Q₉ turns on and the capacitor C₀ is discharged. Accordingly, the voltage V₀ decreases but the output remains at high level V_{H}. When the voltage V₀ reaches the low level threshold S_{L}, the Schmitt circuit D₂ jumps the output F_{OUT} to low level V_{L}. As a result, the transistor Q₃ turns off and the capacitor C₀ is stopped from discharging and begins charging by the current I₄. Hence, the voltage V₀ increases but the output remains at low level V_{L} until the voltage V₀ reaches the high level threshold S_{H}. Waveforms of the signal output from the circuit of Figure 17 are shown in Figure 20, corresponding to the specific power source voltages V_{cc} of V₃, V₄ and V₅. The waveforms are obtained when the constant current supplying source I₀ having a current capacity of I₀ = 2 I₄ is used, and the rectangular pulses have a duty factor of 50%.

Any of the above embodiment circuits can be incorporated in a monolithic integrated circuit, therefore, they are suitably applied to computers like notebook-sized personal computers powered by batteries, hence, resulting in power savings of the computers by lowering the clock signal frequency and the power voltage during operations such as mode selection. The feature of variable frequency clock signals with the use of a single oscillating circuit also results in the reduction of hardware and production cost, while improving the reliability of the computers.

In the above description, examples have been given of circuits employing bipolar transistors. However, the present invention is also applicable to circuits employing other types of transistor such as FETs. In addition, the terms "resistor", "capacitor" and so forth refer to any device or circuit element (or combination of elements) having the desired property of resistance, capacitance, etc.

To summarise, the present invention concerns a constant current circuit whose output current I₂ can be varied with change of a power source voltage V_{cc}, which can be used to control an oscillating circuit whose oscillation frequency can be varied with change of the constant current circuit output current I₂, suitable for use in portable computers. In one form, the constant current circuit comprises bipolar transistors coupled to form a differential amplifier wherein one of the transistors is supplied with a reference voltage and the other is supplied with a divided voltage of the power source voltage V_{cc}, and a resistor connecting the emitters of the transistors is provided for controlling the slope of the V_{cc}-I₂ characteristic curve of the constant current circuit.

## Claims

1. A constant current circuit having a source for supplying a power voltage (V_{cc}), constant current supplying means (I_{A}, I_{B}; I_{D}) including at least one constant current supplying source, first and second transistors (Q₃, Q₅) connected between the power voltage supplying source and the constant current supplying means, each of the transistors having a control electrode, and a resistance means (R₄) including at least one resistor, connected between respective nodes of the first and second transistors and connected to the constant current supplying means; characterised in that the control electrode of the first transistor (Q₃) is provided with a reference voltage (V₁) and the constant current circuit further comprises a voltage divider (R₂, R₃) providing a divided voltage of the power voltage (V_{cc}) for the control electrode of the second transistor;
whereby the current flowing in the second transistor (Q₅) is controlled according to the magnitude of said power voltage, and the rate of change of the current with respect to change of the power voltage depends on the resistance of the resistance means (R₄), said resistance being chosen such that the second transistor (Q₅) outputs a current which linearly changes with the power voltage.

2. A constant current circuit as set forth in claim 1, wherein the constant current supplying means comprises two constant current supplying sources (I_{A}, I_{B}) each connected to a respective one of said nodes of the first and second transistors (Q₃, Q₅), and the resistance means comprises a single resistor (R₄) connected between said nodes of the first and second transistors and between the two constant current supplying sources.

3. A constant current circuit as set forth in claim 1, wherein the constant current supplying means comprises a single constant current supplying source (I_{D}), and wherein the resistance means (R₄) comprises first and second resistors (R₄₁, R₄₂) of equal resistance connected in series between said nodes of the first and second transistors (Q₃, Q₅), the single constant current supplying source (I_{D}) being connected to a node common to both the first and second transistors (R₄₁, R₄₂).

## Patentansprüche

1. Eine Konstantstromschaltung mit einer Quelle zum Zuführen einer Energiespannung (V_{cc}), einem Konstantstromzuführmittel (I_{A}, I_{B}; I_{D}), das wenigstens eine Konstantstromzuführquelle enthält, ersten und zweiten Transistoren (Q₃, Q₅), die zwischen der Energiespannungszuführquelle und dem Konstantstromzuführmittel verbunden sind, von welchen Transistoren jeder eine Steuerelektrode hat, und einem Widerstandsmittel (R₄), das wenigstens einen Widerstand enthält und zwischen jeweiligen Knoten der ersten und zweiten Transistoren verbunden ist und mit dem Konstantstromzuführmittel verbunden ist; dadurch gekennzeichnet, daß die Steuerelektrode des ersten Transistors (Q₃) mit einer Referenzspannung (V₁) versehen ist und die Konstantstromschaltung ferner einen Spannungsteiler (R₂, R₃) umfaßt, der eine geteilte Spannung der Energiespannung (V_{cc}) für die Steuerelektrode des zweiten Transistors vorsieht;
wodurch der Strom, der in dem zweiten Transistor (Q₅) fließt, gemäß der Größe der genannten Energiespannung gesteuert wird und die Veränderungsrate des Stromes bezüglich der Veränderung der Energiespannung von dem Widerstand des Widerstandsmittels (R₄) abhängt, welcher Widerstand so gewählt ist, daß der zweite Transistor (Q₅) einen Strom ausgibt, der sich mit der Energiespannung linear verändert.

2. Eine Konstantstromschaltung nach Anspruch 1, bei der das Konstantstromzuführmittel zwei Konstantstromzuführquellen (I_{A}, I_{B}) umfaßt, die jeweils mit einem entsprechenden der genannten Knoten der ersten und zweiten Transistoren (Q₃, Q₅) verbunden sind, und das Widerstandsmittel einen einzelnen Widerstand (R₄) umfaßt, der zwischen den genannten Knoten der ersten und zweiten Transistoren und zwischen den zwei Konstantstromzuführquellen verbunden ist.

3. Eine Konstantstromschaltung nach Anspruch 1, bei der das Konstantstromzuführmittel eine einzelne Konstantstromzuführquelle (I_{D}) umfaßt, und bei der das Widerstandsmittel (R₄) erste und zweite Widerstände (R₄₁, R₄₂) mit gleichem Widerstandswert umfaßt, die zwischen den genannten Knoten der ersten und zweiten Transistoren (Q₃, Q₅) seriell verbunden sind, welche einzelne Konstantstromzuführquelle (I_{D}) mit einem Knoten verbunden ist, der beiden Widerständen, sowohl dem ersten als auch dem zweiten, (R₄₁, R₄₂) gemeinsam ist.

## Revendications

1. Circuit à courant constant ayant une source pour fournir une tension d'alimentation (Vcc), des moyens fournissant un courant constant (I_{A}, I_{B}; I_{D}) comprenant au moins une source fournissant un courant constant, des premier et deuxième transistors (Q3, Q5) montés entre la source fournissant une tension d'alimentation et les moyens fournissant un courant constant, chacun des transistors ayant une électrode de commande, et des moyens de résistance (R4), comprenant au moins une résistance, montés entre des noeuds respectifs des premier et deuxième transistors et connectés aux moyens fournissant un courant constant, caractérisé en ce que l'électrode de commande du premier transistor (Q3) reçoit une tension de référence (V1) et le circuti à courant constant comprend en outre un diviseur de tension (R2, R3) fournissant une tension divisée de la tension d'alimentation (Vcc) pour l'électrode de commande du deuxième transistor,
ce par quoi le courant circulant dans le deuxième transistor (Q5) est commandé selon l'amplitude de ladite tension d'alimentation, et la vitesse de variation du courant par rapport à la variation de la tension d'alimentation dépend de la résistance des moyens de résistance (R4), ladite résistance étant choisie de telle manière que le deuxième transistor (Q5) fournisse un courant qui varie linéairement avec la tension d'alimentation.

2. Circuit à courant constant selon la revendication 1, dans lequel les moyens fournissant un courant constant comprennent deux sources fournissant un courant constant (I_{A}, I_{B}), chacune connectée à un noeud respectif desdits noeuds des premier et deuxième transistors (Q3, Q5), et les moyens de résistance comprennent une seule résistance (R4) montée entre lesdits noeuds des premier et deuxième transistors et entre les deux sources fournissant un courant constant.

3. Circuit à courant constant selon la revendication 1, dans leque les moyens fournissant un courant constant comprennent une seule source fournissant un courant constant (I_{D}), et dans lequel les moyens de résistance (R4) comprennent des première et deuxième résistances (R41, R42) d'égale résistance montées en série entre lesdits noeuds des premier et deuxième transistors (Q3, Q5), la source unique fournissant un courant constant (I_{D}) étant connectée à un noeud commun aux première et deuxième résistances (R41, R42).
